# EUROPÄISCHE PATENTSCHRIFT

(11) **EP 2 782 221 B1**
(45) Veröffentlichungstag und Bekanntmachung des Hinweises auf die Patenterteilung: **13.06.2018**
(21) Anmeldenummer: 13159840.1
(22) Anmeldetag: 19.03.2013
(51) Int. Cl.: H02K 11/00, H02K 15/00, G01R 31/34, G01K 13/08, H02K 17/16

(54) **Verfahren zur Prüfung einer gestabten Wicklung eines Läufers einer rotierenden elektrischen Maschine**
Method for testing a rod-shaped coil of a rotor of a rotating electrical machine
Procédé de contrôle d'une bobine de rotor d'une machine rotative électrique

(43) Veröffentlichungstag der Anmeldung: 24.09.2014
(73) Patentinhaber: Siemens Aktiengesellschaft, 80333 München (DE)
(72) Erfinder: Zettner, Jürgen, Dr., 90587 Veitsbronn (DE); Deeg, Christian, 90518 Altdorf (DE); Schuhmann, Thomas, Dr., 09112 Chemnitz (DE)

(56) Entgegenhaltungen:
- WO-A1-2009/155954
- WO-A1-2011/020500
- DE-A1- 1 945 343
- US-A- 4 114 077

## Beschreibung

Die vorliegende Erfindung betrifft ein Verfahren zur Prüfung einer gestabten Wicklung eines Läufers einer rotierenden oder linear bewegten elektrischen Maschine, wobei mittels eines in einem Ständer der rotierenden elektrischen Maschine angeordneten Wärmestrahlungssensors eine Wärmestrahlung des Läufers erfasst wird. Darüber hinaus betrifft die Erfindung eine Vorrichtung zur Prüfung einer gestabten Wicklung eines Läufers einer rotierenden elektrischen Maschine, mit einem in einem Ständer der rotierenden elektrischen Maschine angeordneten Wärmestrahlungssensor, mittels dem eine Wärmestrahlung des Läufers erfassbar ist.

Eine elektrische Maschine ist eine Vorrichtung, die elektrische Energie in mechanische Energie, insbesondere Bewegungsenergie (Motorbetrieb) und/oder mechanische Energie in elektrische Energie (Generatorbetrieb) umformt. Eine rotierende elektrische Maschine ist eine elektrische Maschine, bei der ein Ständer eine in der Regel kreisförmige Öffnung bereitstellt, in der ein Läufer drehbar gelagert angeordnet ist. Der Ständer ist gegenüber dem Läufer drehfest angeordnet. Der Ständer und der Läufer sind mittels eines magnetischen Flusses verkettet, wodurch im Motorbetrieb eine Kraftwirkung erzeugt wird, die den Läufer gegenüber dem Ständer drehend antreibt und im Generatorbetrieb dem Läufer zugeführte mechanische Energie in elektrische Energie umwandelt. Zu diesem Zweck weisen der Ständer und der Läufer jeweils eine von einem Strom durchflossene Wicklung auf. Im Ständer oder im Läufer kann die Wicklung auch durch einen Permanentmagneten gebildet oder ergänzt sein.

Rotierende elektrische Maschinen der gattungsgemäßen Art sind dem Stand der Technik bekannt, so dass es eines gesonderten druckschriftlichen Nachweises nicht bedarf. Rotierende elektrische Maschinen der gattungsgemäßen Art sind beispielsweise Drehfeldmaschinen, die an ein mehrphasiges, insbesondere dreiphasiges elektrisches Netz angeschlossen sind, wie Asynchronmaschinen, Synchronmaschinen mit Dämpferkäfig oder dergleichen. Die gestabte Wicklung kann insbesondere eine Käfigwicklung sein, wie sie beispielsweise durch einen Käfig aus Stäben und Kurzschlussringen zum Beispiel bei einem Käfigläufer einer Asynchronmaschine gebildet ist. Die gestabte Wicklung umfasst vorzugsweise Leiterstäbe, die sich im Wesentlichen in eine axiale Richtung des Läufers erstrecken und an den läuferseitigen Enden elektrisch leitend verbunden sind, beispielsweise über Kurzschlussringe oder Stirnverbinder.

Die Läufer gattungsgemäßer elektrischer Maschinen werden bei nicht stationären Betriebsbedingungen thermomechanisch stark beansprucht. Derartige Betriebsbedingungen können beispielsweise durch Maschinenanläufe mit Überstrombedingungen bis zum Erreichen des Nennpunktes, Blockieren der elektrischen Maschine im Betrieb oder dergleichen sein. Dabei können hohe Ströme und Verlustleistungen in den Läuferstäben und im Kurzschlussring auftreten. Wird die elektrische Maschine dann abgeschaltet, bleibt die Verlustwärme im Läufer erhalten, da die Kühlwirkung der abgeschalteten Maschine in der Regel nicht vorhanden ist. Besonders tritt dieser Fall bei einer Eigenkühlung auf, bei der der Läufer zugleich auch ein Kühlsystem antreibt. Besonders die Wärmeenergie des Läufers kann aufgrund der Maschinenkonstruktion nur sehr unzureichend abgeführt werden, wenn keine weitere Kühlwirkung vorgesehen ist. Insbesondere bei wiederholten Belastungen, intermittierendem Betrieb oder dergleichen kann sich der Läufer nach Abschalten der elektrischen Maschine deutlich erwärmen, wobei die exakte Höhe der Erwärmung meist nicht bekannt ist. Insbesondere bei einem erneuten Anlauf der elektrischen Maschine kann dies zu einer thermischen Überbeanspruchung führen.

Die Wärme entsteht in der elektrischen Maschine bei deren Betrieb im Wesentlichen durch folgende Verlustquellen: Stromwärmeverluste, Ummagnetisierungsverluste und Reibungsverluste. Die durch die Verlustquellen erzeugte Wärme führt zu einer thermischen Beanspruchung der elektrischen Maschine. Insbesondere äußert sich diese Beanspruchung in zyklischem Ausdehnen und Zusammenziehen der Maschinenteile, insbesondere der des Läufers. Die Stromwärmeverluste wirken besonders auf die Läuferstäbe, die sich gerade in Längsrichtung thermisch ausdehnen. Dadurch werden Verbindungsstellen der Läuferstäbe, beispielsweise mit einem Kurzschlussring, mechanisch belastet. In der Regel sind solche Verbindungsstellen durch Löten, Schweißen oder Angießen gebildet. Die Wechselbeanspruchung führt an den Verbindungsstellen zu Alterungserscheinungen, die sich beispielsweise in einem erhöhten elektrischen Widerstand im Bereich der Verbindungsstelle zeigen. Die Alterung kann bis zum Bruch einer Verbindungsstelle führen, wodurch die elektrische Maschine letztendlich unbrauchbar wird.

Darüber hinaus führen unterschiedliche elektrische Stabwiderstände sowie auch Übergangswiderstände an den Verbindungsstellen zu Unsymmetrien in der Stromverteilung im Läufer, wodurch lokale Temperaturunterschiede an der Läuferoberfläche die Folge sein können oder auch Momentenpendelungen erzeugt werden können.

Die DE 19 45 343 A offenbart eine Anordnung zur Betriebs- beziehungsweise Temperaturüberwachung rotierender Teile, zum Beispiel eines Läufers, einer, insbesondere elektrischen Maschine.

Die WO 2009/155954 A1 offenbart eine Anordnung mit einer elektrischen Maschine sowie ein Verfahren zum betrieben einer elektrischen Maschine.

Die US 4,114,077 offenbart einen Rotorübertemperaturschutz für elektrische Motoren.

Die WO 2011/020500 A1 betrifft eine Anordnung mit einer elektrischen Maschine, die einen Stator und einen Rotor umfasst, sowie mit einem Infrarot-Temperatursensor, wobei das Detektionsfeld des Infrarot-Temperatursensors auf eine Mantelfläche des Rotors ausgerichtet ist. Dabei ist der Infrarot-Temperatursensor eine Thermosäule zur berührungslosen, radiometrischen Erfassung einer Temperatur des Rotors, die in einer Nut des Stators angeordnet.

Die Erfindung hat es sich zur Aufgabe gemacht, bezüglich der vorgenannten Probleme eine Verbesserung zu erreichen.

Diese Aufgabe wird durch ein Verfahren mit den im Anspruch 1 angegebenen Merkmalen gelöst.

Erstmals ist es mit der Erfindung möglich, detaillierte Informationen bezüglich der thermomechanischen Beanspruchung des Läufers, insbesondere an den diskreten Kontaktierungsstellen zwischen Stab und Kurzschlussring zu erfassen. Hierdurch kann ein Betrieb der elektrischen Maschine optimiert werden, so dass eine lokale Überbeanspruchung des Läufers vermieden werden kann. Die Erfindung erlaubt es darüber hinaus, einsetzende Schadstellen auf dem Läufer rechtzeitig zu erkennen, so dass Gegenmaßnahmen eingeleitet werden können. Weiterhin können Erkenntnisse für die Modellierung elektrischer Maschinen sowie für die Konstruktion dienen. Dabei schlägt die Erfindung insbesondere vor, einen Wärmestrahlungssensor zu nutzen, der sowohl eine geeignete räumliche als auch eine geeignete zeitliche Auflösung bereitstellt, um die gewünschte Auflösung zur Erfassung von einzelnen Stäben des Läufers zu ermöglichen.

Der Wärmestrahlungssensor, der im Ständer der rotierenden elektrischen Maschine angeordnet ist, kann beispielsweise innenseitig am Ständer dem Läufer zugewandt angeordnet sein. So kann der Wärmestrahlungssensor lediglich über den Luftspalt vom Läufer beabstandet sein, so dass der Wärmestrahlungssensor eine räumliche Auflösung erreicht, die es erlaubt, einzelne Stäbe der gestabten Wicklung thermisch zu erfassen. Zu diesem Zweck ist der Wärmestrahlungssensor im Bereich der Wärmestrahlung, insbesondere der Infrarotstrahlung sensitiv.

Der erfasste Bereich des Wärmestrahlungssensors kann beispielsweise 0,01 cm2 bis 10 cm2 umfassen, er kann jedoch an Stababmessungen, insbesondere Stabdurchmesser angepasst gewählt sein, so dass eine zuverlässige Ermittlung der Stabtemperatur erreicht werden kann.

Die Erfindung ermöglicht es somit, insbesondere auch während des bestimmungsgemäßen Betriebs, den Zustand des Läufers mit seinen Bauteilen, insbesondere den Stäben und gegebenenfalls dem Kurzschlussring detektieren zu können. Anders als beim Stand der Technik üblich, können somit genaue lokale Belastungen der elektrischen Maschine ermittelt werden, auch beim kontinuierlichen Betrieb, beim intermittierenden Kurzzeitbetrieb, beim Aussetzbetrieb oder dergleichen. Der Wärmestrahlungssensor selbst kann beispielsweise in einer Ständernut, am Ständerblechpaket oder am Ständergehäuse befestigt sein. Darüber hinaus besteht die Möglichkeit, ständerseitig geeignete Aufnahmen, Ausnehmungen, Bohrungen oder dergleichen vorzusehen, in denen der Wärmestrahlungssensor angeordnet sein kann. Darüber hinaus können optische Beugungsmittel vorgesehen sein, um zu erfassende Wärmestrahlung auf den Wärmestrahlungssensor zu fokussieren. Solche Beugungsmittel können beispielsweise Linsen, Prismen, Kombinationen hiervon oder dergleichen sein.

Eine geeignete Auflösung des Wärmestrahlungssensors ist gegeben, wenn dieser in der Lage ist, die Wärmestrahlung eines einzelnen Stabes der gestabten Wicklung erfassen zu können. Zu diesem Zweck können die vorgenannten Beugungsmittel für die Wärmestrahlung vorgesehen sein.

Um in Umfangsrichtung des Läufers lokale Strahlungswerte erfassen zu können, sieht die Erfindung vor, dass der Läufer rotiert wird. Dabei ist die Drehzahl, mit der der Läufer rotiert wird, kleiner als eine durch die Anzahl der Stäbe der gestabten Wicklung geteilte Grenzfrequenz des Wärmestrahlungssensors. Die Grenzfrequenz des Wärmestrahlungssensors bestimmt die zeitliche Auflösung, mit der der Wärmestrahlungssensor Änderungen hinsichtlich der Wärmestrahlung erfassen kann. Die Grenzfrequenz bestimmt somit eine Reaktionsgeschwindigkeit des Wärmestrahlungssensors in Bezug auf Änderungen der Wärmestrahlung, die auf ihn einwirken. Da die Wärmestrahlung des Läufers stabbezogen erfasst werden soll, sollte nach der Erfindung der Läufer nur so schnell gedreht werden, dass der Wärmestrahlungssensor die einzelnen Läuferstäbe der gestabten Wicklung während des Umlaufs des Läufers auch erfassen kann. Deshalb soll der Wärmestrahlungssensor eine Grenzfrequenz besitzen, die es erlaubt, die Anzahl der Stäbe während eines Läuferumlaufs erfassen zu können. Beträgt beispielsweise die Grenzfrequenz des Wärmestrahlungssensors 75 Hz und weist der Läufer über den Umfang verteilt zehn Läuferstäbe auf, so soll der Läufer mit einer Drehzahl von < 7,5 Umdrehungen pro Sekunde rotiert werden, so dass mit dem Wärmestrahlungssensor die einzelnen Läuferstäbe noch erfasst werden können.

Der Wärmestrahlungssensor setzt die erfasste Wärmestrahlung in ein elektrisches Signal um. Zu diesem Zweck ist der Wärmestrahlungssensor an eine Auswerteeinheit angeschlossen, die das elektrische Signal des Wärmestrahlungssensors abtastet und auswertet. Damit die Auswerteeinheit die Signale des Wärmestrahlungssensors hinreichend vollständig erfassen kann, erfolgt das Abtasten des Wärmestrahlungssensors mit einer Abtastfrequenz, die größer als die mit der Anzahl der Stäbe multiplizierte Drehzahl des Läufers ist. Vorzugsweise ist sie wenigstens doppelt so groß. Dadurch wird gewährleistet, dass die Auswerteeinheit die erfassten Wärmewerte der jeweiligen Stäbe vollständig erfasst. Vorzugsweise werden die erfassten Werte mittels der Auswerteeinheit in digitale Daten umgewandelt, so dass sie der digitalen Signalverarbeitung zur Verfügung gestellt werden können. Dies kann in der Auswerteeinheit integriert sein. Die erfassten Werte des Wärmestrahlungssensors können in gewünschter Weise ausgegeben, beispielsweise angezeigt oder ausgedruckt werden. Darüber hinaus können die Werte auch grafisch bearbeitet werden, so dass eine grafische Anzeige beziehungsweise Darstellung erreicht werden kann. Zu diesem Zweck kann die Auswerteeinheit mit einem Rechner in Kommunikationsverbindung stehen beziehungsweise einen solchen Rechner umfassen. Darüber hinaus können die erfassten Werte einer komplexen Überwachungs- und Steuerungseinheit zugeführt werden, die der Zustandsüberwachung oder Fehlerdiagnose der Anlage dient.

Das Verfahren der Erfindung kann während des bestimmungsgemäßen Betriebs der rotierenden elektrischen Maschine oder auch danach, vorzugsweise an einer betriebswarmen elektrischen Maschine, durchgeführt werden. So kann zum Beispiel der Läufer während des bestimmungsgemäßen Betriebs geprüft werden. Darüber hinaus kann der Läufer auch direkt nach dem Abschalten der rotierenden elektrischen Maschine geprüft werden, zu welchem Zweck die Rotation beim Auslaufen des Läufers genutzt wird. Die aktuelle Drehzahl des Läufers kann anhand der mittels des Wärmestrahlungssensors erfassten Stäbe ermittelt werden. Natürlich kann der Läufer nach Abschalten der Maschine soweit gebremst werden, dass die Bedingung bezüglich der Grenzfrequenz eingehalten wird.

Darüber hinaus kann auch vorgesehen sein, dass der Läufer bei Unterbrechung oder nach Beendigung des bestimmungsgemäßen Betriebs extern angetrieben wird. Zu diesem Zweck kann der Läufer beispielsweise an einen Motor angeschlossen sein, der den Läufer in eine vorgebbare Rotation versetzt. Dies ermöglicht es, auch kurz nach Beendigung eines bestimmungsgemäßen Betriebs läuferrelevante Parameter zu erfassen, um die Prüfung des Läufers durchführen zu können.

Eine weitere Ausgestaltung der Erfindung sieht vor, dass wenigstens zwei in Umfangsrichtung beabstandete Wärmestrahlungssensoren verwendet werden. Die beiden Wärmestrahlungssensoren können in axialer Richtung in der gleichen Position angeordnet sein. Beispielsweise können sie in Umfangsrichtung um 180° versetzt angeordnet sein. Darüber hinaus besteht die Möglichkeit, die Wärmestrahlungssensoren axial versetzt zu einander anzuordnen. In dieser Ausgestaltung können sie auch in Umfangsrichtung im gleichen Winkel zueinander angeordnet sein. Dies ermöglicht es, den Läuferumfang an unterschiedlichen axialen Positionen thermisch zu erfassen. Natürlich kann auch vorgesehen sein, dass die erfassten Wärmestrahlungswerte der Wärmestrahlungssensoren gemeinsam ausgewertet werden, um ein detailreiches Temperaturprofil des Läufers erhalten zu können oder die Prüfung zeitlich zu verkürzen.

Gemäß einer weiteren Ausgestaltung der Erfindung kann der Läufer oder ein Teil des Läufers wie beispielsweise ein Stab mit einer die Wärmeabstrahlung verbessernden Beschichtung beschichtet werden. Hierdurch kann die Genauigkeit der Erfassung verbessert werden beziehungsweise es können Wärmestrahlungssensoren zum Einsatz kommen, die eine geringere Güte aufweisen.

Besonders vorteilhaft erweist es sich, wenn der Wärmestrahlungssensor in einem axialen Bereich der elektrischen Maschine angeordnet ist, in dem einige oder alle Stäbe der Wicklung kontaktiert sind. Auf diese Weise ist möglich, die Kontaktstellen der Stäbe untereinander oder zu einem Kurzschlussring oder dergleichen zu überwachen und rechtzeitig auf Störungen aufmerksam zu werden. Gerade die Verbindungsstellen sind bei thermischer Beanspruchung auch zugleich einer mechanischen Beanspruchung ausgesetzt und bezüglich der Zuverlässigkeit von besonderer Wichtigkeit. Die Erfindung ermöglicht es somit, hier zusätzliche Informationen für die Prüfung zu gewinnen.

Der Wärmestrahlungssensor selbst kann als Thermosäule (thermopile) ausgebildet sein. Eine geeignete Thermosäule kann beispielsweise in einem Sensor integriert sein, der eine Querschnittsfläche von etwa 4 mm² aufweist. So kann die Thermosäule beispielsweise eine Referenzschicht und eine Absorptionsschicht aufweisen, zwischen denen ein Chip, die eigentliche Thermosäule bildend, angeordnet ist. Der Chip kann beispielsweise eine Kantenlänge von 0,1 mm x 0,1 mm aufweisen. Ergänzend kann die Thermosäule zusätzliche optische Beugungsmittel wie Linsen, Prismen oder dergleichen umfassen.

Der Wärmestrahlungssensor ist vorzugsweise in einem Abstand von 2 mm bis 150 mm zum Läufer angeordnet. Natürlich kann entsprechend der Konstruktion der rotierenden elektrischen Maschine auch ein abweichender Abstand vorgesehen sein.

Vorzugsweise beträgt die thermische Auflösung des Wärmestrahlungssensors etwa 1 K. Hierdurch wird eine zuverlässige Erfassung einzelner Stäbe des Läufers erreicht.

Die Abtastrate (sample rate) kann beispielsweise im Bereich von 500 Hz bis 2 kHz ausgewählt werden. Je nach Wärmestrahlungssensor sind auch abweichende Abtastraten möglich, so beispielsweise bei Einsatz von Fotodioden, wie Germanium-Fotodioden, Galliumarsenid-Fotodioden, Silizium-Fotodioden oder dergleichen.

Besonders vorteilhaft erweist es sich, wenn das Auswerten der abgetasteten Werte des Wärmestrahlungssensors ein Vergleichen mit Referenzwerten umfasst. Auf diese Weise ist es möglich, Veränderungen, insbesondere Alterungen am Läufer zu erfassen und gegebenenfalls Gegenmaßnahmen einzuleiten. Gerade bei großen, teuren Maschinen oder bei Maschinen, bei denen besondere Sicherheitsanforderungen oder besondere Anforderungen an die Verfügbarkeit zu beachten sind, kann hierdurch die Zuverlässigkeit insgesamt deutlich verbessert werden. Daraus ergibt sich ein weiteres Ziel der Erfindung, nämlich die Erkennung von defekten Löt-/Schweißstellen, insbesondere zwischen Läuferstab und Kurzschlussring bei einer Asynchronmaschine, sowie die Erkennung von eventuell auftretenden lokalen Grenzbelastungen einzelner Stäbe oder Regionen im Läufer. Ändert sich beispielsweise an einer schadhaften Verbindungsstelle der elektrische Widerstand, führt dies zu einer unsymmetrischen Stromaufteilung im Läufer.

Die Erfindung schlägt ferner eine Vorrichtung zur Prüfung einer gestabten Wicklung eines Läufers einer rotierenden elektrischen Maschine vor mit einem in einem Ständer der rotierenden elektrischen Maschine angeordneten Wärmestrahlungssensor, mittels dem eine Wärmestrahlung des Läufers erfassbar ist, wobei der Wärmestrahlungssensor ausgebildet ist, die Wärmestrahlung einzelner Stäbe der gestabten Wicklung zu erfassen, wobei der Läufer mit einer Drehzahl rotierbar ist, die kleiner als eine durch die Anzahl der Stäbe der gestabten Wicklung geteilte vorgegebene Grenzfrequenz des Wärmestrahlungssensors ist, und der Wärmestrahlungssensor mittels einer Auswerteeinrichtung mit einer Abtastfrequenz abtastbar ist, die größer als die mit der Anzahl der Stäbe multiplizierte Drehzahl des Läufers ist und auswertbar ist.

Die Vorrichtung dient insbesondere zur Durchführung des erfindungsgemäßen Verfahrens.

Durch die Erfindung kann eine lokale Temperatur dynamisch und berührungslos erfasst werden. Lokal variierende elektrische Widerstände haben insbesondere bei dynamischen Betriebsfällen wie Anlauf, Blockade, Drehzahländerung, Laständerung oder dergleichen, lokal abweichende Temperaturen zur Folge, die bisher im Stand der Technik nicht ermittelbar waren. Durch Anordnung eines oder mehrerer Wärmestrahlungssensoren, beispielsweise in Form von Nutenstein-Thermosäulen im Stator, kann die gewünschte Prüfung durchgeführt werden. Vorzugsweise sind die Wärmestrahlungssensoren nahe an einem Übergang zwischen einem Kurzschlussring und einem Stabende oder auch im Bereich des Blechpaketes des Läufers angeordnet.

Die Auswertung der gemessenen Wärmestrahlungswerte, beispielsweise des Läuferblechpaketes beziehungsweise der Läufernuten, erlaubt es, ein Maß für am Messpunkt herrschende Temperaturen, beispielsweise an den Enden des Käfigs beziehungsweise des Läuferstabes zu ermitteln. Hieraus können Abweichungen vom normalen Betriebsverhalten bei Kenntnis des Lastzustandes oder aber abweichende Stabübertemperaturen im Vergleich zu Nachbarstäben erkannt werden. Obwohl sich die Oberfläche des Blechpaketes bereits auf einem hohen Temperaturniveau befindet, kann die Temperatur jedes Läuferstabs genau gemessen werden, da der zugehörige Wärmeemissionsgrad bedingt durch die Nutgeometrie an sich hoch ist.

Die Erfindung nutzt insbesondere Thermosäulen für die Detektion von lokalen Abweichungen einer mittleren Temperatur des Läufers zur Bestimmung von Unsymmetrien im Läuferstromsystem, bedingt beispielsweise durch Kontaktablösungen oder Gussfehler sowie thermische Überlastung einzelner Kontaktstellen.

Insgesamt ergeben sich durch die Erfindung die folgenden Vorteile:
- direkte Messung der Temperatur einzelner Läuferstäbe oder Bereiche im Kurzschlussring oder Übergange zwischen Stab und Kurzschlussring,
- Messung der thermischen Beanspruchung einzelner Stab-Kurzschlussring-Kontaktstellen,
- frühzeitige Detektion von Unsymmetrien im Läufer während des bestimmungsgemäßen Betriebs,
- Vermeidung der Auswertung von Ständerströmen,
- im Wesentlichen keine Modifikation des Läufers erforderlich,
- Erweiterung des zulässigen Betriebsbereichs beziehungsweise eine Erhöhung der thermischen Ausnutzung der rotierenden elektrischen Maschine gegebenenfalls bis zum thermisch kritischen Punkt und
- Verifikation von konstruktiven Änderungen an thermomechanisch hochbeanspruchten Stellen zeitnah und mit geringem Aufwand.

Weitere Vorteile und Merkmale sind der folgenden Beschreibung eines Ausführungsbeispiels zu entnehmen. Das Ausführungsbeispiel dient lediglich der Erläuterung der Erfindung und ist für diese nicht beschränkend.

Es zeigen:
- FIG 1: In schematisch perspektivischer Darstellung einen Läuferkäfig einer Asynchronmaschine ohne Blechpaket,
- FIG 2: den Rotorkäfig gemäß FIG 1 in einer schematischen Seitenansicht mit Blechpaket,
- FIG 3: eine perspektivische Darstellung eines Ausschnitts aus einem Läufer, an dem die Prüfung gemäß der Erfindung vorgenommen werden soll,
- FIG 4: eine schematische perspektivische Darstellung mit vergrößerten Ausschnittsbereichen eines Ständers einer rotierenden elektrischen Maschine, in der der Läufer gemäß FIG 3 im bestimmungsgemäßen Betrieb eingesetzt ist,
- FIG 5: ein Temperatur-Abtastdiagramm, in welchem mittels eines Graphen die mittels einer Thermosäule erfassten, abgetasteten Temperaturwerte dargestellt sind,
- FIG 6-8: graphische Darstellungen von Messergebnissen wie in FIG 5 jedoch bei verschiedenen Drehzahlen des Läufers.

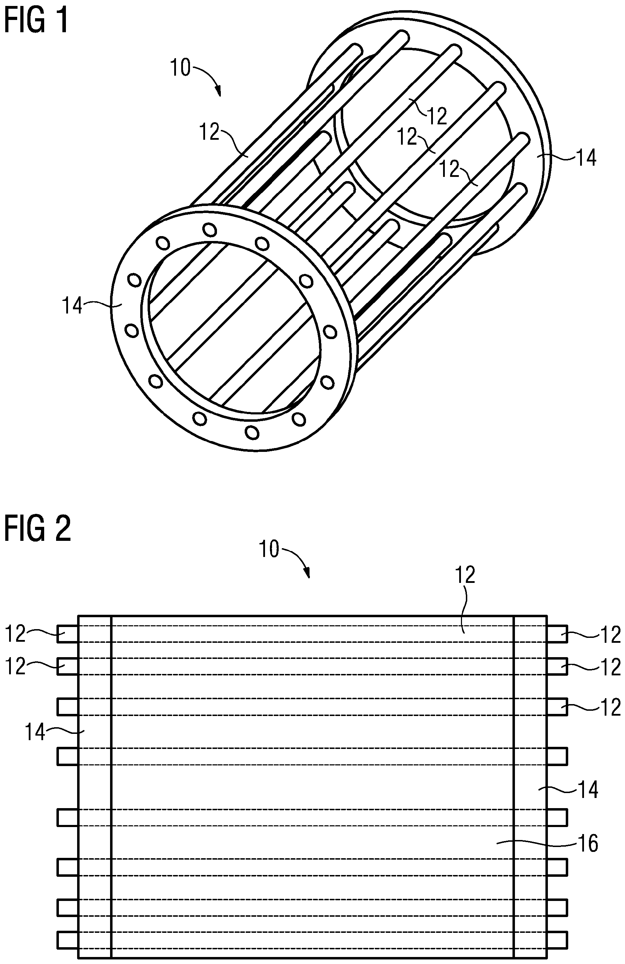

FIG 1 zeigt in einer perspektivischen schematischen Darstellung einen Läuferkäfig 10 eines Läufers 20 einer Asynchronmaschine ohne Blechpaket, wobei der Läuferkäfig 10 Stäbe 12 aufweist, die jeweils endseitig mit einem Kurzschlussring 14 elektrisch leitend verbunden sind. Vorliegend sind sowohl die Stäbe 12 als auch der Kurzschlussring 14 aus einer Kupferlegierung gebildet und die Stäbe 12 endseitig am Kurzschlussring 14 verlötet, verschweißt oder angegossen. Aus der schematischen Seitenansicht des Läuferkäfigs 10 in FIG 2 ist ersichtlich, dass die einzelnen Stäbe 12 endseitig geringfügig durch den jeweiligen Kurzschlussring 14 hindurchragen.

FIG 2 zeigt ergänzend zum Läuferkäfig 10 das Blechpaket 16, das aus isolierten Elektroblechen besteht, die zum Blechpaket 16 gestapelt angeordnet sind. Das Blechpaket 16 weist nicht bezeichnete Nuten auf, in denen die Stäbe 12 angeordnet sind.

Wird der auf diese Weise konstruierte Läufer thermisch beansprucht, erfolgt eine unterschiedliche Ausdehnung der Stäbe 12 gegenüber dem Blechpaket 16 sowie gegenüber dem Kurzschlussring 14. Daraus ergibt sich eine thermische Beanspruchung innerhalb des Läufers 10. Außerdem werden die freien Stabenden beansprucht, da sie einseitig im Blechpaket gehalten werden, der Kurzschlussring sich aber radial ausdehnt.

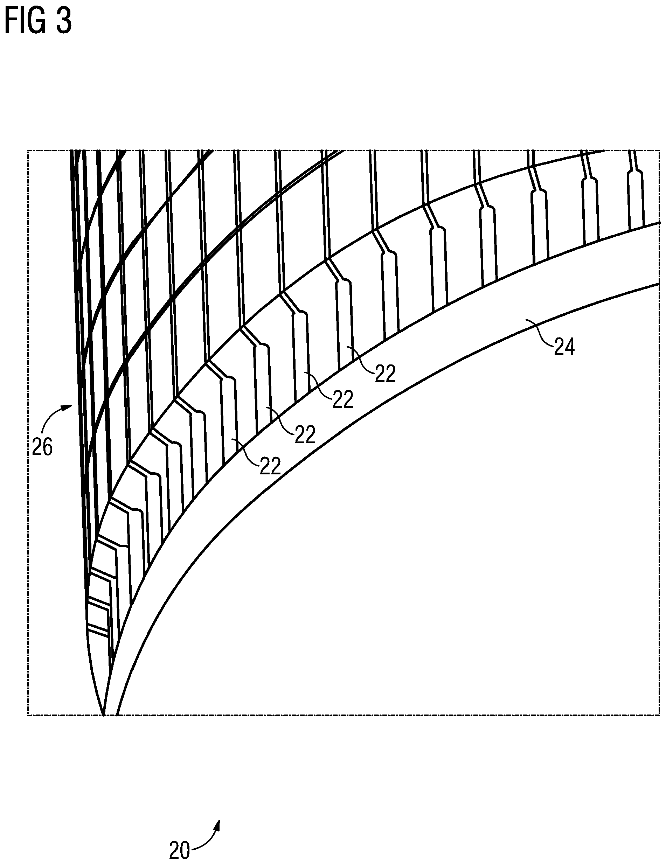

FIG 3 zeigt einen Läufer 20 einer Drehstromasynchronmaschine 30 im ausgebauten Zustand in fotografischer Ansicht ausschnittsweise. Der Läufer 20 weist ein Blechpaket 26 auf, das nicht bezeichnete Nuten umfasst, in die Stäbe 22 eingeführt sind. Endseitig sind die Stäbe 22 mit einem Kurzschlussring 24 verschweißt. Der Aufbau des Läufers gemäß FIG 3 entspricht damit im Wesentlichen dem des in FIG 2 dargestellten Läufers.

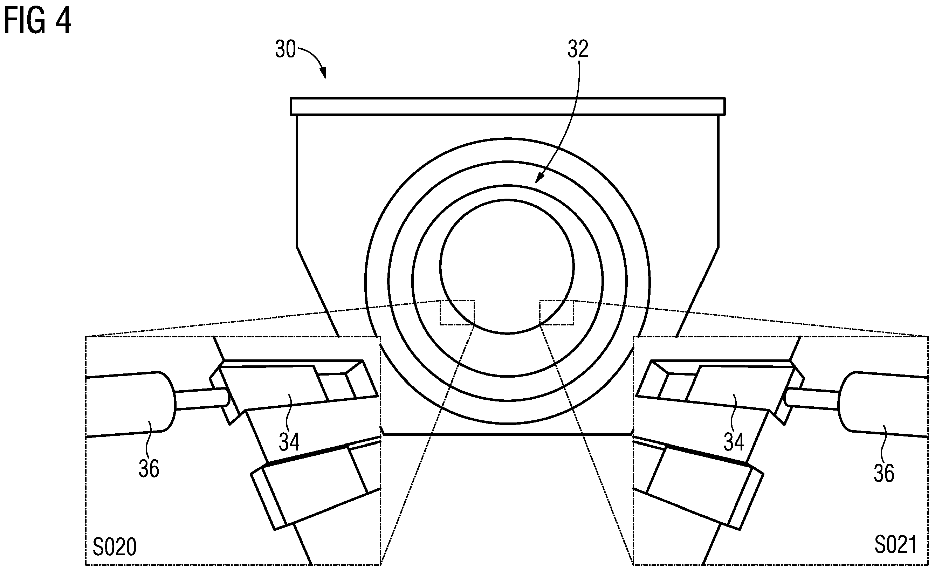

FIG 4 zeigt eine elektrische Maschine 30 mit einem Ständer 32 in dem der Läufer 20 gemäß FIG 3 im bestimmungsgemäßen Betrieb drehbar angeordnet ist. Aus zwei Detaildarstellungen der FIG 4 ist ersichtlich, wie die Wärmestrahlungssensoren, die hier als Thermosäulen 34 ausgebildet sind, in Nuten des Ständers 32 angeordnet sind. Die Thermosäulen 34 sind als Nutensteine ausgebildet und über elektrische Leitungen 36 an eine nicht dargestellte Auswerteeinheit angeschlossen.

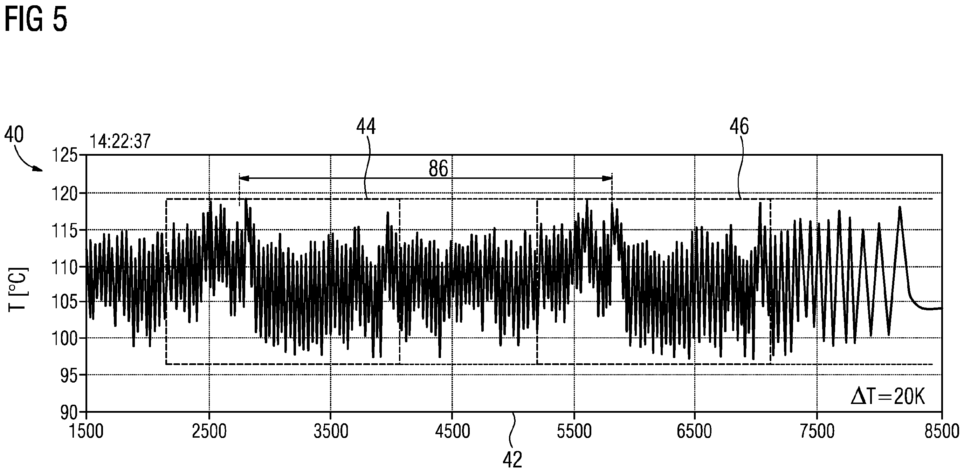

Die folgenden Diagramme der FIG 5-8 beziehen sich auf die elektrische Maschine 30 gemäß FIG 4 mit dem Läufer gemäß FIG 3. Die Anordnung der Thermosäulen 34 gemäß FIG 4 ist eine Ausgestaltung gemäß diesem Ausführungsbeispiel. Bedarfsweise können die Thermosäulen 34 natürlich an anderen geeigneten Positionen am Umfang des Ständers 32 sowie auch an geeigneten axialen Positionen angeordnet sein.

In dem Diagramm gemäß FIG 5 ist auf der Ordinate die Temperatur in Grad Celsius eingetragen. Auf der Abszisse sind die Abtastzeitpunkte aufgetragen. Die Abtastrate beträgt vorliegend etwa 500 Hz. In der Messung gemäß FIG 5 rotiert der Läufer mit einer Drehzahl von 10 pro min. Es ist ersichtlich, dass wiederkehrende Signaturen im Abstand von 86 Perioden in der Läufertemperatur zu erkennen sind. Der Dynamikumfang Δ T beträgt etwa 20 K. Die Periodenanzahl ist zurückzuführen auf die Läufernutzahl der elektrischen Maschine 30 und beträgt somit ebenfalls 86. In dem Diagramm gemäß FIG 5 sind Bereiche 44 und 46 dargestellt, die sich wiederholende Signaturen im Temperaturverlauf aufzeigen. Daraus ist ersichtlich, dass die beiden dargestellten Signaturen 44, 46 aufeinanderfolgenden Umdrehungen zuzuordnen sind.

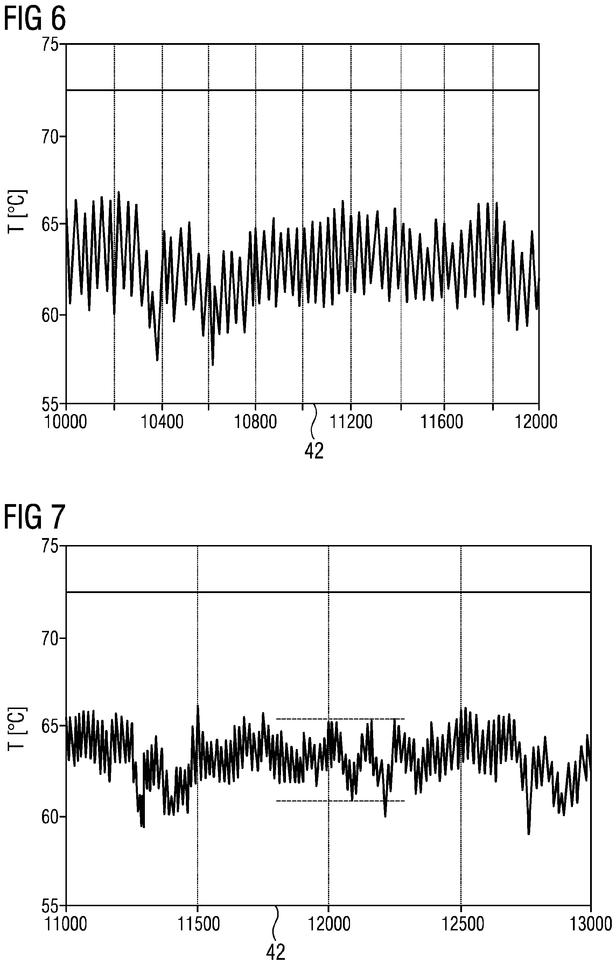

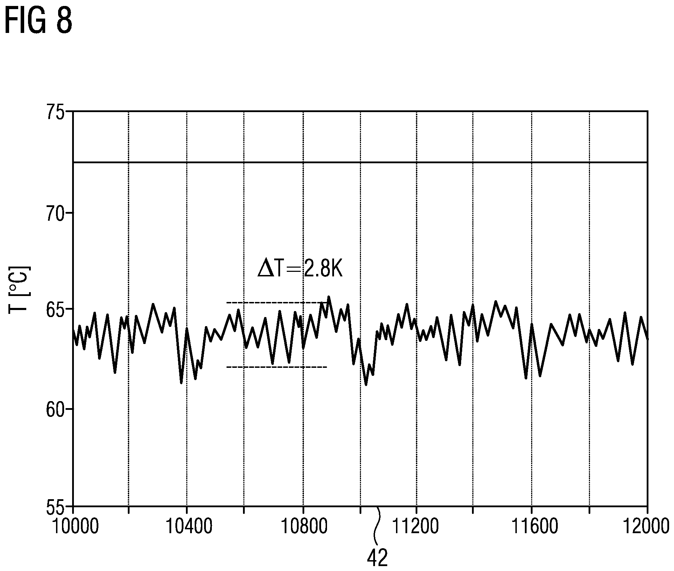

Die FIG 6-8 beziehen sich auf einen externen Antrieb des Läufers 20, das heißt, die elektrische Maschine 30 ist nicht im aktiven Zustand. Die Achsen sind entsprechend FIG 5 zugeordnet. FIG 6 zeigt eine Darstellung bei einer Läuferdrehzahl von 10 Umdrehungen pro Minute, wohingegen die FIG 7 sich auf eine Läuferdrehzahl von 20 Umdrehungen pro Minute und die FIG 8 auf eine Läuferdrehzahl von 50 Umdrehungen pro Minute bezieht. Die weiteren Parameter sind für alle drei Figuren gleich. Aus den FIG 6-8 ist ersichtlich, wie sich die Läuferdrehzahl auf das Messergebnis auswirkt. Mit zunehmender Annäherung der stabbezogenen Läuferdrehzahl an die Grenzfrequenz der Thermosäule 34 nimmt die Messgenauigkeit der lokalen Läufertemperatur ab.

## Patentansprüche

1. Verfahren zur Prüfung einer gestabten Wicklung eines Läufers (20) einer rotierenden elektrischen Maschine (30), wobei mittels eines in einem Ständer (32) der rotierenden elektrischen Maschine (30) angeordneten Wärmestrahlungssensors (34) eine Wärmestrahlung des Läufers (20) erfasst wird, wobei mittels des Wärmestrahlungssensors (34) die Wärmestrahlung einzelner Stäbe (22) der gestabten Wicklung erfasst wird, wobei das Verfahren ferner umfasst:
- Rotieren des Läufers (20) mit einer Drehzahl, die kleiner als eine durch die Anzahl der Stäbe (22) der gestabten Wicklung geteilte vorgegebene Grenzfrequenz des Wärmestrahlungssensors (34) ist,
- Erfassen der Wärmestrahlung des Läufers (20) mittels des Wärmestrahlungssensors (34),
- Abtasten des Wärmestrahlungssensors (34) mit einer Abtastfrequenz, die größer als die mit der Anzahl der Stäbe (22) multiplizierte Drehzahl des Läufers (20) ist,
- Auswerten der abgetasteten Werte des Wärmestrahlungssensors (34),
wobei der Läufer (20) bei Unterbrechung oder nach Beendigung eines bestimmungsgemäßen Betriebs extern angetrieben wird.

2. Verfahren nach Anspruch 1,
wobei das Verfahren während des bestimmungsgemäßen Betriebs der rotierenden elektrischen Maschine (30) oder danach durchgeführt wird.

3. Verfahren nach Anspruch 1 oder 2,
wobei das Auswerten der abgetasteten Werte des Wärmestrahlungssensors (34) ein Vergleichen mit Referenzwerten umfasst.

4. Verfahren nach einem der Ansprüche 1 bis 3,
wobei wenigstens zwei in Umfangsrichtung beabstandete Wärmestrahlungssensoren (34) verwendet werden.

5. Verfahren nach einem der Ansprüche 1 bis 4,
wobei der Läufer (20) mit einer die Wärmeabstrahlung verbessernden Beschichtung beschichtet wird.

6. Verfahren nach einem der Ansprüche 1 bis 5,
wobei der Wärmestrahlungssensor (34) in einem axialen Bereich der elektrischen Maschine (30) angeordnet ist, in dem einige oder alle Stäbe (22) der Wicklung kontaktiert sind.

7. Verfahren nach einem der Ansprüche 1 bis 6,
wobei als Wärmestrahlungssensor (34) eine Thermosäule verwendet wird.

8. Verfahren nach einem der Ansprüche 1 bis 7,
wobei mittels eines innenseitig an dem Ständer (32) der rotierenden elektrischen Maschine (30) dem Läufer (20) zugewandt angeordneten Wärmestrahlungssensors (34) die Wärmestrahlung des Läufers (20) erfasst wird.

9. Vorrichtung zur Prüfung einer gestabten Wicklung eines Läufers (20) einer rotierenden elektrischen Maschine (30), mit einem in einem Ständer (32) der rotierenden elektrischen Maschine (30) angeordneten Wärmestrahlungssensor (34), mittels dem eine Wärmestrahlung des Läufers (20) erfassbar ist, wobei der Wärmestrahlungssensor (34) ausgebildet ist, die Wärmestrahlung einzelner Stäbe (22) der gestabten Wicklung zu erfassen, wobei der Läufer (20) mit einer Drehzahl rotierbar ist, die kleiner als eine durch die Anzahl der Stäbe (22) der gestabten Wicklung geteilte vorgegebene Grenzfrequenz des Wärmestrahlungssensors (34) ist, und der Wärmestrahlungssensor (34) mittels einer Auswerteeinrichtung mit einer Abtastfrequenz abtastbar ist, die größer als die mit der Anzahl der Stäbe (12) multiplizierte Drehzahl des Läufers (20) ist und auswertbar ist, wobei der Läufer (20) bei Unterbrechung oder nach Beendigung eines bestimmungsgemäßen Betriebs extern angetrieben wird.

10. Vorrichtung zur Prüfung einer gestabten Wicklung eines Läufers (20) einer rotierenden elektrischen Maschine (30) nach Anspruch 9 zur Durchführung eines Verfahrens nach einem der Ansprüche 1 bis 8.

## Claims

1. Method for testing a bar winding of a rotor (20) of a rotating electrical machine (30), wherein thermal radiation of the rotor (2) is detected by means of a thermal radiation sensor (34), which is arranged in a stator (32) of the rotating electrical machine (30), wherein the thermal radiation of individual bars (22) of the bar winding is detected by means of the thermal radiation sensor (34), wherein the method also comprises:
- rotating the rotor (20) at a speed that is lower than a predefined limit frequency of the thermal radiation sensor (34) divided by the number of bars (22) of the bar winding,
- detecting the thermal radiation of the rotor (20) by means of the thermal radiation sensor (34),
- sampling the thermal radiation sensor (34) at a sampling frequency that is higher than the rotational speed of the rotor (20) multiplied by the number of bars (22),
- evaluating the sampled values of the thermal radiation sensor (34),
wherein the rotor (2) is driven externally in the event of disruption or once normal operation has ended.

2. Method according to claim 1,
wherein the method is carried out during normal operation of the rotating electrical machine (30) or thereafter.

3. Method according to claim 1 or 2,
wherein the evaluation of the sampled values of the thermal radiation sensor (34) includes a comparison with reference values.

4. Method according to one of claims 1 to 3,
wherein at least two thermal radiation sensors (34) that are spaced apart in the circumferential direction are used.

5. Method according to one of claims 1 to 4,
wherein the rotor (20) is coated with a coating that improves thermal radiation.

6. Method according to one of claims 1 to 5,
wherein the thermal radiation sensor (34) is arranged in an axial region of the electrical machine (30) in which some or all bars (22) of the winding are contacted.

7. Method according to one of claims 1 to 6,
wherein a thermopile is used as the thermal radiation sensor (34) .

8. Method according to one of claims 1 to 7,
wherein the thermal radiation of the rotor (20) is detected by means of a thermal radiation sensor (34), which is arranged on the inside of the stator (32) of the rotating electrical machine (30), so as to face the rotor (20).

9. Device for testing a bar winding of a rotor (20) of a rotating electrical machine (30), having a thermal radiation sensor (34), which is arranged in a stator (32) of the rotating electrical machine (30), by means of which thermal radiation of the rotor (20) can be detected, wherein the thermal radiation sensor (34) is designed to detect the thermal radiation of individual bars (22) of the bar winding, wherein the rotor (20) can be rotated at a speed that is lower than a predefined limit frequency of the thermal radiation sensor (34) divided by the number of bars (22) of the bar winding, and the thermal radiation sensor (34) can be sampled by means of an evaluation device at a sampling frequency that is greater than the rotational speed of the rotor (20) multiplied by the number of bars (12), and evaluated, wherein the rotor (2) is driven externally in the event of disruption or once normal operation has ended.

10. Device for testing a bar winding of a rotor (20) of a rotating electrical machine (30) according to claim 9 for carrying out a method according to one of claims 1 to 8.

## Revendications

1. Procédé de contrôle d'un bobinage pourvu de barreaux d'un rotor (20) d'une machine (30) électrique tournante,
dans lequel, au moyen d'un capteur (34) du rayonnement thermique, monté dans un stator (32) de la machine (10) électrique tournante, on détecte un rayonnement thermique du rotor (20), dans lequel, au moyen du capteur (34) de rayonnement thermique, on détecte le rayonnement thermique de barreaux (22) individuels du bobinage pourvu de barreaux, le procédé comprenant en outre :
- la rotation du rotor (20) à une vitesse de rotation, qui est plus petite qu'une fréquence limite du capteur (34) du rayonnement thermique, donnée à l'avance, divisée par le nombre des barreaux (22) du bobinage pourvu de barreaux,
- la détection du rayonnement thermique du rotor (20) au moyen du capteur (34) de rayonnement thermique,
- l'étalonnage du capteur (34) du rayonnement thermique à une fréquence d'étalonnage, qui est plus grande que la vitesse de rotation du rotor (20) multipliée par le nombre de barreaux (22),
- l'exploitation des valeurs étalonnées du capteur (34) du rayonnement thermique,
dans lequel on entraîne le rotor (20) de l'extérieur, après arrêt ou que s'est achevé un fonctionnement conforme aux prescriptions.

2. Procédé suivant la revendication 1,
dans lequel on effectue le procédé pendant le fonctionnement conforme aux prescriptions de la machine (30) électrique tournante ou ensuite.

3. Procédé suivant la revendication 1 ou 2,
dans lequel l'exploitation des valeurs échantillonnées du capteur (34) du rayonnement thermique comprend une comparaison à des valeurs de référence.

4. Procédé suivant l'une des revendications 1 à 3,
dans lequel on utilise au moins deux capteurs (34) du rayonnement thermique à distance dans la direction périphérique.

5. Procédé suivant l'une des revendications 1 à 4,
dans lequel on revêt le rotor (20) d'un revêtement améliorant le rayonnement thermique.

6. Procédé suivant l'une des revendications 1 à 5,
dans lequel le capteur (34) du rayonnement thermique est monté dans une partie axiale de la machine (30) électrique, dans laquelle certains ou tous les barreaux (22) du bobinage sont contactés.

7. Procédé suivant l'une des revendications 1 à 6,
dans lequel on utilise une thermopile comme capteur (34) du rayonnement thermique.

8. Procédé suivant l'une des revendications 1 à 7,
dans lequel on détecte le rayonnement thermique du rotor (20) au moyen d'un capteur (34) du rayonnement thermique, monté du côté intérieur sur le stator (32) de la machine (30) électrique tournante, en étant tourné vers le rotor (20).

9. Dispositif de contrôle d'un bobinage pourvu de barreaux d'un rotor (20) d'une machine (30) électrique tournante, comprenant un capteur (34) du rayonnement thermique, qui est monté dans un rotor (32) de la machine (30) électrique tournante et au moyen duquel un rayonnement thermique du rotor (20) peut être détecté, dans lequel le capteur (34) du rayonnement thermique est constitué de manière à détecter le rayonnement thermique de barreaux (22) individuels du bobinage pourvu de barreaux, le rotor (20) pouvant tourner à une vitesse de rotation, qui est plus petite qu'une fréquence limite du capteur (34) du rayonnement thermique donnée à l'avance, divisée par le nombre des barreaux (22) du bobinage pourvu de barreaux, et le capteur du rayonnement thermique pouvant être étalonné au moyen d'un dispositif d'exploitation à une fréquence d'étalonnage, qui est plus grande que la vitesse de rotation du rotor (20) multipliée par le nombre des barreaux (22) et qui peut être exploitée, le rotor (20) étant, lorsqu'il est arrêté ou après qu'un fonctionnement conforme aux prescriptions est achevé, entraîné de l'extérieur.

10. Dispositif de contrôle d'un bobinage pourvu de barreaux d'un rotor (20), d'une machine (30) électrique tournante suivant la revendication 9, pour effectuer un procédé suivant l'une des revendications 1 à 8.
